# EUROPEAN PATENT APPLICATION

(11) **EP 3 819 945 A1**
(43) Date of publication of application: **12.05.2021**
(21) Application number: 19207373.2
(22) Date of filing: 06.11.2019
(51) Int. Cl.: H01L 29/66, H01L 29/78

(54) **METHOD OF FORMING A VERTICAL CHANNEL DEVICE**

(71) Applicant: Imec VZW, 3001 Leuven (BE)
(72) Inventor: HIBLOT, Gaspard, 3001 Leuven (BE); BAUDOT, Sylvain, 3001 Leuven (BE)
(74) Representative: AWA Sweden AB

(57) **Abstract**

The present invention provides a method of forming a vertical channel transistor structure (1), comprising the steps of a) forming a bottom source/drain region (3a) on a substrate surface (2) and depositing a spacer oxide layer (13) over said bottom source/drain region (3a); b) forming vertically extending portions (5) and depositing gate material (4) on the deposited spacer oxide layer (13) such that the gate material is arranged over said bottom source/drain region (3a) and over said deposited spacer oxide layer (13) and wherein said vertically extending portions (5) are arranged around and are extending above said gate material (4); c) depositing spacer material (6) at sidewalls of said vertically extending portions (5), thereby defining a horizontal gap (7) between said vertically extending portions (5), said gap (7) being positioned vertically over said gate material (4) and said bottom source/drain portion (3a). The method further comprises the steps of d) forming a vertical opening (8) through said gate material (4) extending from said horizontal gap (7) down to said bottom source/drain region (3a); e) depositing an oxide (10) at the sidewalls of said gate material (4) in said vertical opening (8); and f) performing an epitaxial deposition process of a semiconductor material on said bottom source/drain portion (3a) to form a vertical channel structure (9) above said gate (4), wherein the width (w1) of the vertical channel structure (9) through said gate (4) is defined by the width of the horizontal gap (9) after said depositing of step e); g) planarizing the formed structure (1), thereby reducing the height of the vertical channel structure (9) and the deposited spacer material (6); and h) forming a top source/drain portion (3b) over the vertical channel structure (9).

## Description

### Technical field

The present inventive concept relates to the field of semiconductor devices.

More particularly it relates to a vertical channel device and a method of forming a vertical channel device.

### Background

Vertical channel devices are being developed due to a need to provide more powerful and area-efficient semiconductor devices. Due to having regions arranged in the vertical direction, these devices may be scaled more efficiently to decrease the overall device footprint.

Vertical gate all around (GAA) devices are one of the main contenders for CMOS scaling beyond 5 nm because they feature excellent channel control thanks to their gate wrapped around the channel, while they enable significant gain in transistor density thanks to their vertical structure. In addition, they have other benefits, including lower gate edge roughness and sharper junction profiles obtained through vertical processes, such as epitaxial growth and deposition instead of implant and etch used for horizontal channels.

However, one particular problem is that vertical channels, or vertical nanowires, may be sensitive to gate/channel overlay, which is usually not a problem in horizontal channel devices in which the channel is self-aligned to the gate. Thus, in a vertical channel device, the channel is no longer self-aligned to the gate. As a result of such overlay misalignment between gate and channel, the device characteristics can be severely degraded by e.g. Vth (threshold voltage) deviation if the gate overlap of the channel becomes too thin or even absent on one side of the vertical channel.

Vertical channels may be produced using two different process flows; channel-first, in which the channel is provided by etching, or channel-last, comprising embedded epi growth of the channel.

In US 9209247, gate/channel misalignment is compensated by aligning the gate on the channel in a channel-first flow, such that protruding gate portions are used to compensate for any overlay. This solution creates additional parasitic capacitances that are degrading the speed of the semiconductor device.

Furthermore, US 2019/0081156 discloses a channel-first flow to obtain an aligned channel after a trimming operation.

However, there is a need in the art for improved methods for providing vertical channel devices having a self-aligned channel on the gate.

### Summary

It is an object of the invention to at least partly overcome one or more limitations of the prior art. In particular, it is an object to provide a vertical channel device having a self-aligned channel on the gate and a method of forming such a vertical channel device.

As a first aspect of the invention, there is provided a method of forming a vertical channel transistor structure, comprising the steps of
a) forming a bottom source/drain region (3a) on a substrate surface (2) and depositing a spacer oxide layer (13) over said bottom source/drain region (3a);
b) forming vertically extending portions (5) and depositing gate material (4) on the deposited spacer oxide layer (13) such that the gate material is arranged over said bottom source/drain region (3a) and over said deposited spacer oxide layer (13) and wherein said vertically extending portions (5) are arranged around and are extending above said gate material (4);
c) depositing spacer material (6) at sidewalls of said vertically extending portions (5), thereby defining a horizontal gap (7) between said vertically extending portions (5), said gap (7) being positioned vertically over said gate material (4) and said bottom source/drain portion (3a);
d) forming a vertical opening (8) through said gate material (4) extending from said horizontal gap (7) down to said bottom source/drain region (3a);
e) depositing an oxide (10) at the sidewalls of said gate material (4) in said vertical opening (8);
f) performing an epitaxial deposition process of a semiconductor material on said bottom source/drain portion (3a) to form a vertical channel structure (9) above said gate (4), wherein the width (w1) of the vertical channel structure (9) through said gate (4) is defined by the width of the horizontal gap (9) after said depositing of step e);
g) planarizing the formed structure (1), thereby reducing the height of the vertical channel structure (9) and the deposited spacer material (6); and
h) forming a top source/drain portion (3b) over the vertical channel structure (9).

The method of the first aspect of the invention is thus a channel-last process flow, in which a channel structure is epitaxially grown on the first, lower source/drain portion to provide a vertical channel transistor structure.

As used herein, the term vertical denotes a direction being parallel to a vertical geometrical axis extending perpendicular to the substrate. The terms "above", "below", "upper" and "lower" are thus used to refer to relative positions along the vertical axis. In addition, the term lateral or horizontal refers to the direction perpendicular to the vertical direction, i.e. to the direction parallel to the substrate surface.

In the context of the present disclosure, a "vertical channel structure" is a structure in which the current flow of charge carriers between a source region and a drain region is perpendicular to the substrate surface, i.e. along the normal to the main surface of the substrate, during use of the

The vertical channel transistor structure may thus be a semiconductor transistor structure having a channel that is oriented vertically with respect to the substrate surface, i.e. comprising a vertical channel structure as discussed above in which the net direction of charge is along the normal to the surface of the substrate during use. As an example, the vertical channel transistor structure may be a field-effect transistor (FET).

The first aspect of the invention is based on the insight that forming a vertically extending portions around a gate in a channel-last process allows for self-alignment of the vertical channel over the gate. The lateral width of the vertical channel may be adjusted by how much spacer material that is deposited at the sidewalls of the vertically extending portions before etching and epitaxial growth of the channel. Thus, the method of the first aspect allows for a straighter channel profile compared to when using e.g. trimming operations.

As an example, the method of the first aspect of the invention may be realized by use a gate mask to define two "negative gate" hard masks whose spacers are used to define the opening of the gate around the channel through which the channel is grown. Such an embedded epi growth of the channel enables a self-aligned channel with respect to the gate mask.

Thus, in embodiments of the first aspect, the deposition of the gate material in step b) is performed using a first hard photoresist mask and the formation of the vertically extending portions around the gate in step b) is performed using a second hard photoresist mask, wherein the second hard photoresist mask is the negative of the first hard photoresist mask, at least over the gate region of the device.

Step a) of forming a bottom source/drain region on a substrate surface may for example be performed by straight etching in a substrate wafer, thereby forming a bottom source/drain region. The substrate surface may be a semiconductor material, such as a single crystalline, polycrystalline or amorphous semiconductor material. As an example, the substrate may be single crystalline silicon.

The bottom source/drain region may be of the same material as the substrate or of a different material. As an example, the bottom source/drain region may comprise
epitaxially grown SiGe, which is grown on a Si substrate. Other suitable materials for the bottom source/drain region include Si:C on a Si substrate, InGaAs on an InP substrate and GaAs on a GaAs substrate.

In embodiments of the first aspect, step a) also comprises forming insulating material around the sides of the bottom source/drain region. This insulating material may for example be an STI oxide, such as silicon dioxide.

Step a) also comprises depositing a spacer oxide layer over the bottom source/drain region. The spacer oxide may for example be any suitable Inter Layer Dielectric (ILD). As an example, the spacer oxide layer may include a low-k dielectric material such as silicon oxide, boron nitride or silicon carbon boron nitride.

Step b) comprises the formation of vertically extending portions and the deposition of gate material. These substeps may be performed in any order.

Thus, in embodiments of the first aspect, the gate material is deposited before formation of the vertically extending portions in step b). This may then be patterned and thereafter the vertically extending portions may be formed at positions where the gate material is removed, i.e. in a "fill and recess" or "etch-back" process.

However, in embodiments of the first aspect, the gate material is deposited after formation of the vertically extending portions in step b). Thus, the vertically extending portions may first be formed, such as using a "fill and recess" or "etch-back" process, the gate material may then be deposited in between the vertically extending portions.

The vertically extending portions are formed so that they extend over the formed gate. The vertically extending portions may extend all around the gate, thereby forming a continuous vertically extending portion around the gate. The vertically extending portions may also be formed so that they extend on two opposite sides of the gate, as seen in a cross-section through the gate. Thus, step b) may comprise forming two vertically extending portion on either side of the deposited gate material, as seen in a cross-section in a plane parallel to the normal of the substrate.

The vertically extending portions may comprise a dielectric nitride, such as SiN.

In embodiments of the first aspect, the vertically extending portions comprises SiN. Thus, the vertically extending portions may consist of SiN.

The vertically extending portions can be formed utilizing a deposition process such as, for example, PVD, PECVD or CVD.

The gate material deposited in step b) may be the material of the final gate of the vertical channel transistor structure, such as a final metal gate. However, the gate material deposited in step b) may also be a dummy gate material that is replaced later in the process, such as after step g).

Depositing spacer material at the sidewalls of step c) may be performed using conventional conformal deposition methods. The spacer material may be SiN. Thus, in embodiments of the first aspect, the vertically extending portions comprises or consist of SiN, and also the spacer material deposited in step c) comprises or consists of SiN.

The spacer material is deposited at the sidewalls such that a small lateral gap is left between the vertical structures. This gap is positioned vertically over the gate material deposited in between the vertically extending portions and over the bottom source/drain portion. The depositing of spacer material of step c) may comprise a first deposition of spacer material, followed by a spacer etch. The spacer etch may include an anisotropic etch to remove spacer material that has been deposited on horizontal surfaces.

Examples of etching that may be used for etching the deposited spacer material is reactive-ion etching RIE.

Examples of deposition processes that can be used in depositing the spacer material include, for example, CVD, PVD, PECVD or atomic layer deposition (ALD).

Forming the vertical opening of step d) may include lithography and etching. Lithography may include forming a photoresist layer atop the deposited and etched spacer layer, which may be patterned using a pattern of irradiation as known in the art. Etching may then be performed at the areas exposed in the pattern. Thus, the vertical opening of step d) may include etching processes, such as a straight etch process through the gate down to the bottom source/drain region.

The formation of the vertical opening in step d) may thus lead to the formation of a final gate, i.e. when an opening is formed through the deposited gate material.

Consequently, in embodiments of the first aspect, step d) comprises forming a patterned photoresist layer over the deposited spacer material such that an opening in the photoresist layer overlays with the position of the gap, and wherein step d) further comprises straight etching in the opening to form the opening through the gate material.

As an alternative, forming the vertical opening in step d) may comprise etching without photoresist, with an etch that is self-aligned on the vertically extending portions.

Further, the method may also comprise forming vertically openings on the opposite sides of the vertically extending portions, i.e. at the sides of the vertically extending portions that do not face the gap. These openings may form the position of vertically extending channels in other transistor structures being formed next to the vertically channel transistor structure.

After a vertical opening down to the bottom source/drain region has been performed in step d), an oxide is deposited at the exposed sidewall of the gate in step e). This oxide thus functions as a gate oxide isolating the gate from the subsequently formed vertical channel. The gate oxide may be any material as know for a person skilled in the art such as Silicon oxide (SiO₂, SiON), or high-K dielectrics such as HfO₂, HfSiN or HfSiO.

Depositing of the oxide at the exposed sidewalls in step e) may comprise a conformal deposition of the oxide, thus covering both the sidewalls of the gate in the vertical opening and the lateral surface in the opening and next to the opening. Step e) may then comprise a straight etch to remove deposited oxide at the lateral surfaces, thereby leaving gate oxide deposited at the exposed sidewalls of the gate. The straight etch may be performed by anisotropic etching, i.e. orientation dependent etching, of the exposed lateral surfaces. The anisotropic etch of the gate oxide, e.g. SiO₂ and HfO₂, may be performed with plasma (dry) using Carbon Fluoride chemistry.

The vertical channel portion is epitaxially grown in step f). The channel is grown such that is extends vertically above the gate. The semiconductor material grown on the bottom source/drain portion to form the vertical channel structure may be selected from the group consisting of silicon, silicon germanium (SiGe), silicon carbide (SiC), Silicon carbon germanium (SiCGe), germanium (Ge) and group III-V compounds.

In embodiments of the first aspect, the semiconductor material used for epitaxially growing the vertical channel structure in step f) is a different semiconductor material than the material of the bottom source/drain portion.

The semiconductor material forming the vertical channel structure may be either monocrystalline, polycrystalline or amorphous.

Furthermore, the horizontal cross section of the vertical channel structure may for example be circular, square, hexagonal, rectangular, or triangular.

After growing the vertical channel structure, a step of planarization to reduce the height of the vertical channel structure is performed in step g). This step also reduces the height of the spacer material previously deposited in step c).

The planarization may for example be performed using chemical mechanical planarization (CMP).

In embodiments of the first aspect, the planarization of step g) reduces the spacer material to a targeted spacer thickness of the final vertical channel transistor structure.

Thus, the spacer material as deposited in step c) may form a final gate spacer in the vertical channel transistor structure.

However, as a complement or an alternative, in embodiments of the first aspect, step h) further comprises replacing the spacer material deposited in step c) with a lower-κ material.

Thus, the planarizing of step g) may include complete removal of the deposited spacer material of step c).

A lower κ-material may be a low-κ dielectric material having a dielectric constant that is less than 7.0. Exemplary low-κ dielectric materials that can be used include, but are not limited to, silicon oxide, boron nitride and silicon carbon boron nitride.

In embodiments of the first aspect, the gate is a dummy gate, and wherein the method further comprises a step of replacing the dummy gate with a final gate.

The dummy gate may comprise or consist of sacrificial gate portions. Consequently, the method may comprise a replacement gate process (RMG).

The dummy gate may include a dielectric material that can be selectively removed with respect to other structures of the vertical channel transistor structure. For example, the dummy gate may include a dielectric metal oxide or a dielectric oxide. As an example, the dummy gate may comprise silicon dioxide.

The replacement of a dummy gate with a final gate may be performed after step g).

However, it is also to be understood that the method may be a direct gate process, i.e. the gate material deposited in step b) may be the "real" gate metal of the final vertical channel transistor structure.

In embodiments of the first aspect, the bottom source/drain region has a width (w2) in a horizontal direction that is larger than the width of the gap, such that the vertical channel structure formed in step f) has a width (w1) in a horizontal direction that is equal to or smaller than the width (w2) of the bottom source/drain region.

As an example, the bottom source/drain region may have a width w2 at the interface between the bottom source/drain region and the channel region that is larger than the width of the gap.

As a second aspect of the invention, there is provided a vertical channel transistor device comprising
a substrate;
a vertical semiconductor structure arranged on the substrate; the vertical semiconductor structure comprising a bottom source/drain region, a top source/drain region and a channel structure extending vertically from the bottom source/drain region to the top source/drain region;
a gate extending vertically along the channel structure; wherein
the bottom source/drain region has a width (w2) that is equal to or larger in a horizontal direction than the width (w1) of the channel structure.

This aspect may generally present the same or corresponding advantages as the former aspect. Effects and features of this second aspect are largely analogous to those described above in connection with the first and second aspects. Embodiments mentioned in relation to the first aspects are largely compatible with the second aspect.

A vertical channel transistor device having a source/drain region with a width (w2) that is equal to or larger in a horizontal direction than the width (w1) of the channel structure may facilitate production of such a device, since it may compensate for any misalignment with any mask used in the process of forming the vertical channel structure, such as with a mask used for forming vertically extending portions around gate material as discussed in relation to the first aspect above.

If w2 is equal to or larger than w1, then the channel epitaxial growth may start at a full semiconductor surface, instead of at a mix of semiconductor/dielectric surface, as could be the case if w1>w2. Thus, having w2 equal to or larger than w1, facilitates a regular shape of the channel structure and a reliable production process.

In embodiments of the second aspect, the bottom source/drain region has a width (w2) that is larger in a horizontal direction than the width (w1) of the channel structure.

As an example, the width w2 may be larger than w1 in all horizontal directions. Thus, the cross-section of the channel structure may have an area that is confined in the area of cross-section of the bottom source/drain region, as seen in a plane parallel to the substrate. Thus, the bottom junction may enclose the vertical channel structure.

The vertical channel transistor device may be a FET device.

As an example, the width w2 may be larger than the width w1 in all horizontal directions.

In embodiments of the second aspect, the bottom source/drain region has a width (w2) that is equal to or larger in a horizontal direction than the width (w1) of the channel structure at the interface between the bottom source/drain region and the channel structure.

Thus, the vertically uppermost portion of the bottom source/drain region may have a width that is wider than the width of the vertical channel structure.

In embodiments of the second aspect, the channel structure is formed of a semiconductor material different from the material of the top and bottom source/drain regions.

As an example, the channel structure may be of a material selected from the group consisting of silicon, silicon germanium (SiGe), silicon carbide (SiC), Silicon carbon germanium (SiCGe), germanium (Ge) and group III-V compounds.

The bottom source/drain region may be selected from doped silicon, silicon germanium (SiGe), silicon carbide (SiC), Silicon carbon germanium (SiCGe), germanium (Ge) and group III-V compounds.

Furthermore, the gate may be a metal gate or a replacement gate.

In embodiments of the second aspect, the substrate is of a different material than the bottom source/drain region.

The substrate may be a semiconductor material, such as a single crystalline, polycrystalline or amorphous semiconductor material. As an example, the substrate may be single crystalline silicon. In one embodiment, the semiconductor substrate has a (111) crystalline orientation.

In embodiments of the second aspect, the gate surrounds the channel structure such that the vertical channel transistor device is configured as a gate-all-around field effect transistor.

Thus, the gate material may surround the vertical channel structure on all sides as seen in a horizontal cross-section through the device. The vertical channel structure may thus extend vertically through the gate.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.

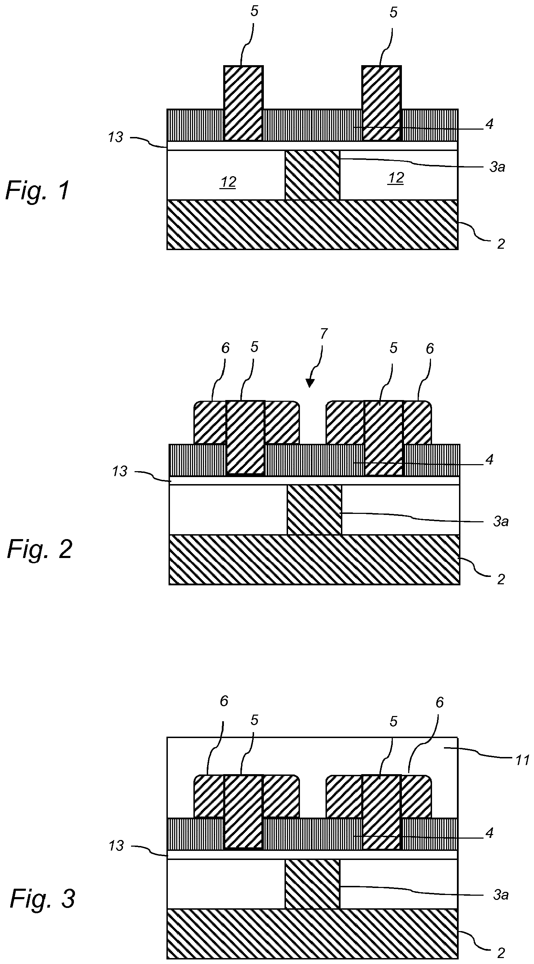

Figs. 1-9 illustrate different steps in the formation of a vertical channel transistor structure.

### Detailed description

In the above the inventive concept has mainly been described with reference to a limited number of examples. However, as is readily appreciated by a person skilled in the art, other examples than the ones disclosed above are equally possible within the scope of the inventive concept, as defined by the appended claims.

Figs. 1-9 show different steps in the method of forming a vertical channel transistor structure of the present disclosure. In Fig. 1 a starting substrate 2 is provided. This substrate 2 may be a semiconductor substrate, i.e. a substrate comprising at least one semiconductor layer. The substrate 2 may be a single-layered semiconductor substrate, for instance formed by a bulk substrate. The substrate 2 may however also be a multi-layered substrate, for instance formed by an epitaxially grown semiconductor layer on a bulk substrate, or a semiconductor-on-insulator (SOI) substrate.

The method comprises forming a bottom source/drain region 3a on the substrate surface 2 and depositing a spacer oxide layer 13 over the bottom source/drain region 3a.

The spacer oxide layer 13 may be provided by conformal deposition. As an example, the spacer oxide layer 13 may include a low-k dielectric material such as boron nitride or silicon carbon boron nitride.

Further, an insulating material 12, e.g. STI oxide, such as silicon dioxide is formed around the bottom source/drain portion 3a, i.e. around the lateral sidewalls of the bottom source/drain portion 3a. The bottom source/drain portion 3a may have been performed by a straight etch at selected areas in the substrate 2 to provide a bottom source/drain portion 3aextending above the etched substrate 2, and thereafter a deposition of isolation material 12 around the bottom source/drain portion 3a.

However, as an alternative, the substrate 2 may be of a different material than the bottom source/drain region 3a. Thus, the bottom source/drain region 3a may have been formed by an epitaxial growth of a material different from the material of the substrate 2 on selected areas of the surface of the substrate 2.

Thereafter, as illustrated in Fig. 1, gate material 4 has been deposited using planar deposition onto the spacer oxide layer 13. In this gate material, vertically extending portions 5 have been formed around a gate region that is vertically above the bottom source/drain region 3a. These vertically extending portions 5 may be formed by a first planar deposition of APF material (not shown). This material can then be patterned using the negative of a gate mask, i.e. with a mask having openings around the position of the final gate 4. Then, etching at the positions of the vertically extending portions 5 down through the deposited gate material may be performed to allow for filling or epitaxial growth of the material of the vertically extending portions 5. This material may be SiN. The structure may then be planarized and the remains of the deposited APF may be removed, to provide the structure as illustrated in Fig. 1. Consequently, Fig. 1 illustrates the steps of
a) forming a bottom source/drain region 3a on a substrate surface 2 and depositing a spacer oxide layer 13 over said bottom source/drain region 3a;
b) forming vertically extending portions 5 and depositing gate material 4 on the deposited spacer oxide layer 13 such that the gate material is arranged over said bottom source/drain region 3a and over said deposited spacer oxide layer 13 and wherein said vertically extending portions 5 is arranged around and is extending above said gate material 4;
As discussed above, the gate material is in this example deposited before the formation of the vertically extending portions. However, the structure as illustrated in Fig. 1 may be formed by first forming the vertically extending portions 5 and thereafter depositing spacer material over the bottom source/drain region 3a.

Furthermore, it is to be understood that the substrate 2, the bottom source drain region 3a, the gate 4 and the vertically extending portions 5 etc may typically present other lateral/horizontal extension than shown. It may further be noted that the relative dimensions of the shown structures, for instance the relative thickness of layers, is merely schematic and may, for the purpose of illustrational clarity, differ from a physical device structure.

In Fig. 2, a spacer material 6 has been conformally deposited over the structure as illustrated in Fig. 1, before being anisotropically (top-down) etched to form the spacer material 6 at the lateral sidewalls of the vertically extending portions 6 that faces each other. The spacer material 6 may also be of SiN. The deposition of the spacer material 6 is performed such that there is still a horizontal gap 7 between the vertically extending portions. This gap is positioned vertically over the gate 4 and the bottom source/drain portion 3a. thus, Fig. 2 illustrates the step of
c) depositing spacer material 6 at sidewalls of the vertically extending portions 5, thereby defining a horizontal gap 7 between the vertically extending portions 5, the gap being positioned vertically over the gate material 4 and the bottom source/drain portion 3a

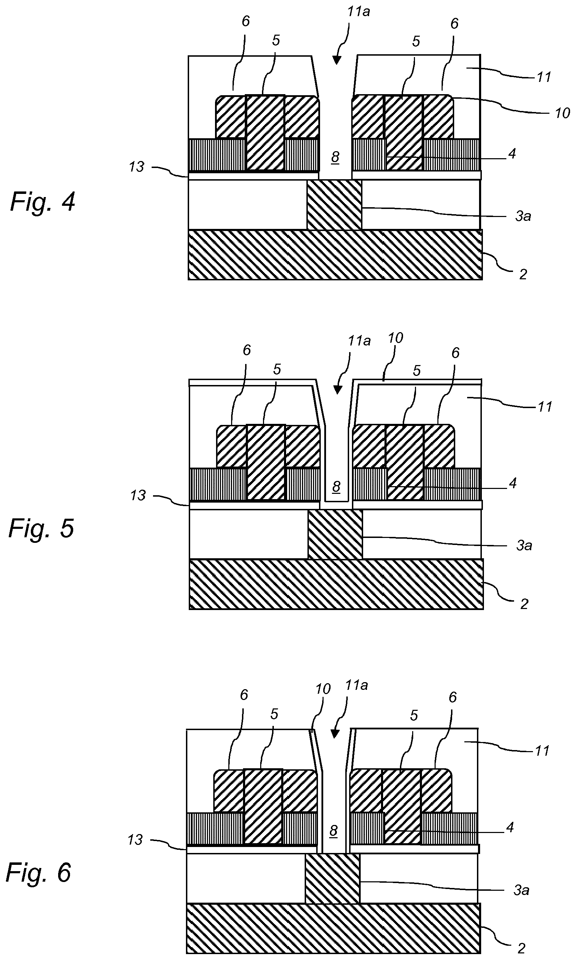

Figs. 3 and 4 illustrate the formation of a vertical opening 8 in the gap 7 defined by the horizontal distance between the spacer material 6 deposited at the sidewalls of the vertically extending portions 5. The gap 7 is positioned over the gate 4 and the bottom source/drain portion 3a, and the vertical opening 8 thus extend down to the bottom source/drain portion 3a. The opening may be formed by first depositing a photoresist layer 11 conformally over the top surfaces and in the gap 7, as illustrated in Fig. 3. This photoresist layer may be patterned such that an opening 11a in the photoresist layer 11 overlays with the position of the gap 7, as illustrated in Fig. 4. Thereafter, straight etching may be performed to open up through the gate 4 down to the bottom source/drain portion 3a. Thus, Figs. 3 and 4 illustrate step d) of the present disclosure, i.e. forming a vertical opening (8) through the gate (4) extending from the horizontal gap (7) down to the bottom source/drain region (3a);

After the opening 8 has been formed, an oxide 10 is deposited using conformal deposition. This is illustrated in Fig. 5. The oxide layer 10 may then be anisotropically (top-down) etched to form the spacers at the sidewalls of the gate, as illustrated in Fig. 6. Consequently, Figs. 5 and 6 illustrate step d) of forming a vertical opening 8 through the gate material 4 extending from the horizontal gap 7 down to the bottom source/drain region (3a) and step e) of depositing an oxide 10 at the sidewalls of the gate material 4 in the vertical opening (8).

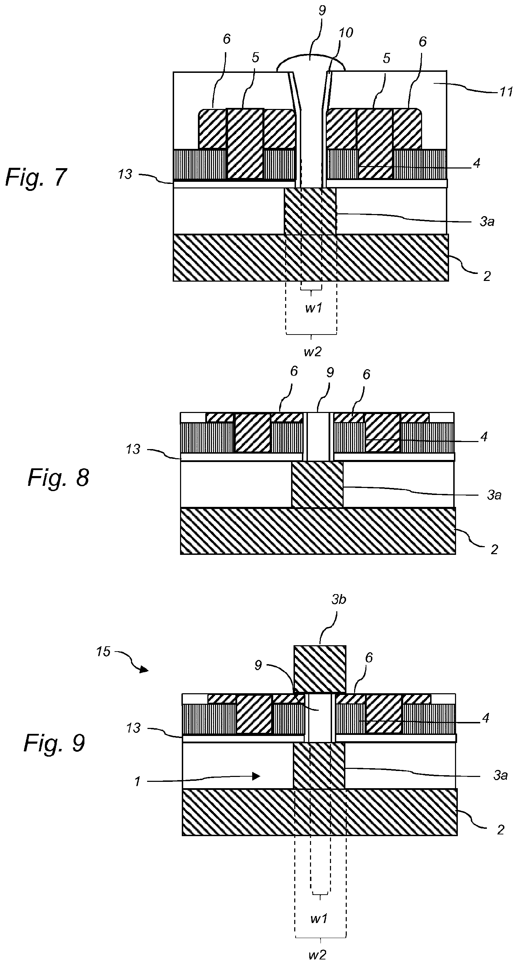

The vertical channel structure 9 may then be epitaxially grown onto the exposed surface of the bottom source/drain region 3a such that the vertical channel structure extends within the opening 8 vertically above the gate 4, as illustrated in Fig. 7. Thus, the width w1 of the vertical channel structure through the gate 4 is defined by the width of the horizontal gap 9 between the vertical channel structures after the deposition process of step e).

Consequently, Fig. 7 illustrates the step of f) performing an epitaxial deposition process of a semiconductor material on the bottom source/drain portion 3a to form a vertical channel structure 9 above the gate 4, wherein the width (w1) of the vertical channel structure 9 through the gate 4 is defined by the width of the horizontal gap 9 after the depositing of step e);

The semiconductor material of the channel structure may be the same as the semiconductor material of the bottom source/drain region 3a. The material of the vertical channel structure may be selected from the group consisting of silicon, silicon germanium (SiGe), silicon carbide (SiC), silicon carbon germanium (SiCGe), germanium (Ge) and group III-V compounds.

However, as an alternative, the channel structure 9 may be formed of a semiconductor material different from the material of the bottom source/drain region 3a.

After epitaxial growth of the vertical channel structure 9, the formed structure is planarized using e.g. chemical-mechanical polishing (CMP), as illustrated in Fig. 8. This thus reduces the height of the formed structure, including the height of the vertical channel structure (9) and the deposited spacer material (6). The planarizing may reduce the deposited spacer material 6 at the sidewalls of the vertically extending portions to a targeted spacer thickness of the final vertical channel transistor structure. Thus, the deposited spacer material 6 in step c) may after planarization form spacers of the gate 4, i.e. spacers arranged on top of the gate 4. Consequently, Fig. 8 illustrates step g) of planarizing the formed structure 1, thereby reducing the height of the vertical channel structure 9 and the deposited spacer material 6.

However, step g) may also comprise replacing the spacer material 6 with a lower-κ material.

A lower κ-material may be a low-κ dielectric material having a dielectric constant that is less than 7.0. Exemplary low-κ dielectric materials that can be used include, but are not limited to, boron nitride and silicon carbon boron nitride.

The gate 4 formed as discussed in relation to Fig. 1 may be a dummy gate. Thus, the method of the present disclosure may further comprise a step of replacing the dummy gate 4 with a final gate. This step may be performed after the planarization of step g)

After the planarization of step g), a top source/drain portion 3b is formed over the vertical channel structure 9. This is illustrated in Fig. 9. Such a top source/drain portion 3b may be formed using deposition or e.g. performing a second epitaxial growth onto the top surface of the vertical channel structure 9.

Consequently, Fig. 9 illustrates step h) of forming a top source/drain portion 3b over the vertical channel structure 9.

The bottom and top source/drain portions 3a, 3b may form source/drain terminals of the final vertical channel transistor structure 15. In an example, the bottom source/drain portion 3a is formed by an n-doped selective epitaxial silicon or silicon carbon process, using for instance P, As or Sb as dopants, whereas the top source/drain portion 3b is formed by a p-doped selective epitaxial silicon or silicon germanium process. In the latter example, B or Ga may be used as dopants.

However, as discussed herein above, also doped silicon carbide (SiC), silicon carbon germanium (SiCGe), germanium (Ge) and group III-V compounds may be used to form source/drain terminals of the final vertical channel transistor structure 15.

The structure as illustrated in Fig. 9 may thus be a vertical channel transistor device 15 comprising a substrate 2, a vertical semiconductor structure 1 arranged on the substrate 2. The vertical semiconductor structure 1 comprises a bottom source/drain region 3a, a top source/drain region 3b and a channel structure 9 extending vertically from the bottom source/drain region 3a to the top source/drain region 3b. The device 15 further comprises a gate 4 extending vertically along the channel structure 9. As illustrated in Fig. 9, the bottom source/drain region 3a has a width w2 that is larger in a horizontal direction than the width w1 of the channel structure 9

As an example, the width w2 may be larger than the width w1 in all horizontal directions.

Further, as also illustrated in Fig. 9, the bottom source/drain region 3a has a width w2 that is larger in a horizontal direction than the width w1 of the channel structure 9 at the interface between the bottom source/drain region 3a and the channel structure 9.

The resulting vertical channel transistor device me be refer gate-all-around (GAA). Thus, the gate region 4 may surround the channel structure 9 such that the vertical channel transistor device 15 is configured as a gate-all-around field effect transistor.

GAA devices may provide an improved control of the transistor device at a lower operating voltage.

Further, the vertical channel transistor device may comprise a gate contact (not shown) for providing means for controlling the gate 4 of the device 15.

## Claims

1. A method of forming a vertical channel transistor structure (1), comprising the steps of
a) forming a bottom source/drain region (3a) on a substrate surface (2) and depositing a spacer oxide layer (13) over said bottom source/drain region (3a);
b) forming vertically extending portions (5) and depositing gate material (4) on the deposited spacer oxide layer (13) such that the gate material is arranged over said bottom source/drain region (3a) and over said deposited spacer oxide layer (13) and wherein said vertically extending portions (5) are arranged around and are extending above said gate material (4);
c) depositing spacer material (6) at sidewalls of said vertically extending portions (5), thereby defining a horizontal gap (7) between said vertically extending portions (5), said gap (7) being positioned vertically over said gate material (4) and said bottom source/drain portion (3a);
d) forming a vertical opening (8) through said gate material (4) extending from said horizontal gap (7) down to said bottom source/drain region (3a);
e) depositing an oxide (10) at the sidewalls of said gate material (4) in said vertical opening (8);
f) performing an epitaxial deposition process of a semiconductor material on said bottom source/drain portion (3a) to form a vertical channel structure (9) above said gate (4), wherein the width (w1) of the vertical channel structure (9) through said gate (4) is defined by the width of the horizontal gap (9) after said depositing of step e);
g) planarizing the formed structure (1), thereby reducing the height of the vertical channel structure (9) and the deposited spacer material (6); and
h) forming a top source/drain portion (3b) over the vertical channel structure (9).

2. A method according to any previous claim, wherein step a) also comprises forming insulating material (12) around the sides of said bottom source/drain region (3a).

3. A method according to any previous claim, wherein the gate material (4) is deposited before formation of the vertically extending portions (5) in step b).

4. A method according to claims 1 or 2, wherein the gate material (4) is deposited after formation of the vertically extending portions (5) in step b).

5. A method according to any previous claim, wherein step d) comprises forming a patterned photoresist layer (11) over said deposited spacer material (6) such that an opening (11a) in said photoresist layer (11) overlays with the position of said gap (7), and wherein step d) further comprises straight etching in said opening (11a) to form said opening (8) through said gate material (4).

6. A method according to any previous claim, wherein said vertically extending portions (5) comprises SiN.

7. A method according to any previous claim, wherein the planarization of step g) reduces the spacer material (6) deposited in step d) to a targeted spacer thickness of the final vertical channel transistor structure (1).

8. A method according to any previous claim, wherein step g) comprises replacing the spacer material (6) with a lower-κ material.

9. A method according to any previous claim, wherein said gate material (4) deposited in step b) forms a dummy gate, and wherein the method further comprises a step of replacing said dummy gate with a final gate.

10. A method according to any previous claim, wherein said bottom source/drain region (3a) has a width (w2) in a horizontal direction that is larger than the width of said gap (7), such that said vertical channel structure (9) formed in step f) has a width (w1) in a horizontal direction that is equal to or smaller than the width (w2) of said bottom source/drain region (3a).

11. A vertical channel transistor device (15) comprising
a substrate (2);
a vertical semiconductor structure (1) arranged on said substrate (2); said vertical semiconductor structure comprising a bottom source/drain region (3a), a top source/drain region (3b) and a channel structure (9) extending vertically from said bottom source/drain region (3a) to said top source/drain region (3b);
a gate (4) extending vertically along the channel structure (9); wherein
said bottom source/drain region (3a) has a width (w2) that is equal to or larger in a horizontal direction than the width (w1) of said channel structure (9).

12. A vertical channel transistor device (1) according to claim 11, wherein said bottom source/drain region (3a) has a width (w2) that is equal to or larger in a horizontal direction than the width (w1) of said channel structure (9) at the interface between said bottom source/drain region (3a) and said channel structure (9).

13. A vertical channel transistor device (1) according to claim 11 or 12, wherein the channel structure (9) is formed of a semiconductor material different from the material of said top (3b) and bottom (3a) source/drain regions.

14. A vertical channel transistor structure according to any one of claims 11-13, wherein the substrate (2) is of a different material than said bottom source/drain region (3a).

15. A vertical channel transistor device (1) according to any one of claims 11-14, wherein the gate (4) surrounds the channel structure (9) such that the vertical channel transistor device (15) is configured as a gate-all-around field effect transistor.
